# EUROPEAN PATENT SPECIFICATION

(11) **EP 0 436 322 B1**
(45) Date of publication and mention of the grant of the patent: **09.03.1994**
(21) Application number: 90313533.3
(22) Date of filing: 12.12.1990
(51) Int. Cl.: B23K 1/00, B23K 31/12, H05K 13/08

(54) **Method of checking external shape of solder portion**
Verfahren zur Prüfung der äusseren Form einer Lötzone
Méthode d'examen de la forme extérieure d'une partie brasée

(30) Priority: 13.12.1989 JP 323351/89
(43) Date of publication of application: 10.07.1991
(73) Proprietor: MATSUSHITA ELECTRIC INDUSTRIAL CO., LTD., Kadoma-shi, Osaka-fu, 571 (JP)
(72) Inventor: Tokura, Nobufumi, Sawara-ku, Fukuoka-shi (JP)
(74) Representative: Sorrell, Terence Gordon

(56) References cited:
- EP-A- 0 209 650
- EP-A- 0 355 377
- 1990 IEEE INTERNATIONAL CONFERENCE ON ROBOTICS AND AUTOMATION, Cincinnati,Ohio, 13th - 18th May 1990, pages 1290-1295; J.-S. PARK et al.: "A solder jointinspection system for automated printed circuit board manufacturing"

## Description

The present invention relates to a method of checking the external shape of a solder portion. More particularly, in a method of checking the external shape of a solder portion wherein the solder portion is sweepingly irradiated with a laser beam and light reflected from the solder portion is detected by a position sensor, the invention consists of setting reasonable criteria for the acceptance or rejection of the solder shape so as to objectively check the external shape of the solder portion.

A method to judge the acceptance or rejection of a solder shape wherein a solder portion for bonding an electronic component to a circuit board is sweepingly irradiated with a laser beam and light reflected from the solder portion is detected by a position sensor is known (refer to, for example, the official gazettes of Japanese patent applications laid-open No. 177042/1988 and No. 177045/1988).

Heretofore, however, the actual circumstances have been that a criterion for the acceptance or rejection of the solder shape is not definite, so the acceptance or rejection is judged somewhat arbitrarily or subjectively. Accordingly, for the purpose of establishing a technique based on the sweeping projection of a laser beam for the judgement of the acceptance or rejection of the solder shape, it is necessary to set a reasonable criterion as a premise and to check the external appearance of the solder portion in accordance with the criterion.

### SUMMARY OF THE INVENTION :

An object of the present invention is to provide a method of checking the external shape of a solder portion for objectively judging the acceptance or rejection of the solder shape.

A method of checking an external shape of a solder portion wherein a laser beam is sweepingly projected along the solder portion and light reflected from the solder portion is detected by a position sensor, characterised in that it comprises the steps of:- setting an upper-limit height and a lower-limit height for the solder portion based on a thickness of either an electronic component or a lead of such component, and comparing a maximum height of the measured soldered portion with the set upper-limit height and the lower-limit height respectively; and setting a lower-limit inclination angle of a solder fillet which forms at least part of the solder portion, and comparing an inclination angle of the measured solder fillet with the set lower-limit inclination angle, whereby the acceptance or rejection of the solder portion shape is judged from the aforesaid comparisons.

With the checking method as described above, the maximum height or the wetting angle of the solder portion is measured by sweepingly projecting a laser beam along the solder portion and then detecting light reflected from the solder portion, and the measured value is compared with the preset upper-limit height, lower-limit height or lower-limit wetting angle, whereby the acceptance or rejection of the solder shape is judged.

### BRIEF DESCRIPTION OF THE DRAWINGS :

Fig. 1 is a perspective view showing a solder shape checking apparatus for use in the embodiments of the present invention;
Figs. 2(a), 2(b) and 2(c) are sectional views each showing a solder portion;
Fig. 3 is a side view for illustrating the procedure for taking a measurement;
Figs. 4 and 5 are graphs each showing a measured result; and
Fig. 6 is a side view showing a chip of a mini-transistor.

### PREFERRED EMBODIMENTS OF THE INVENTION :

The embodiments of the present invention will be described with reference to the drawings.

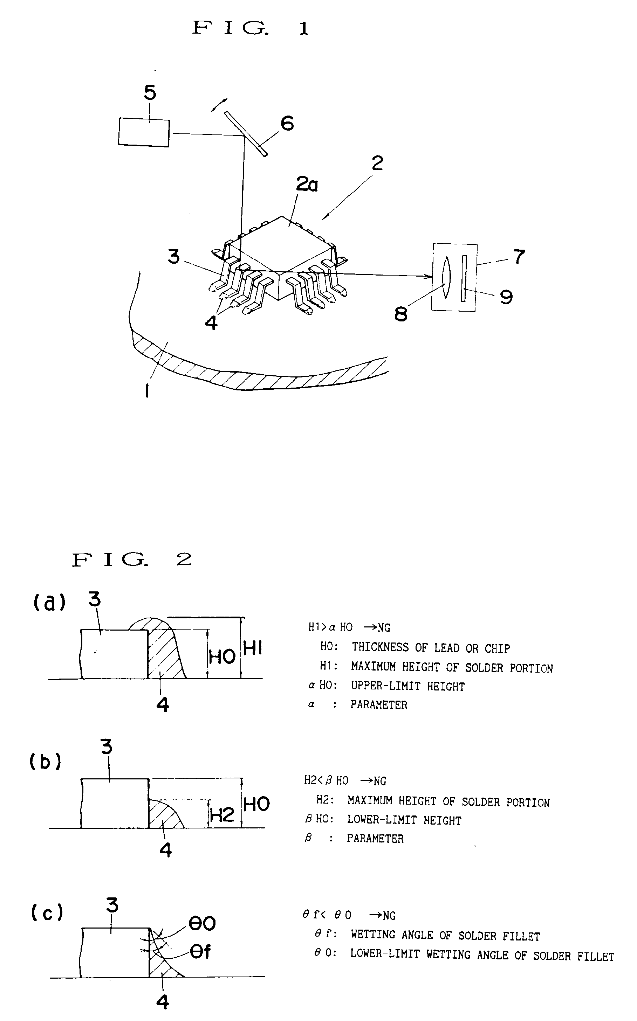

Fig. 1 is a perspective view of an apparatus for checking the external shape of a solder portion. Numeral 1 designates a circuit board, on the upper surface of which an electronic component (hereinbelow, termed "chip") 2 is mounted. Numeral 3 indicates a lead which extends from a mould member 2a of the chip 2, and numeral 4 a solder portion for bonding the lead 3 to the circuit board 1. Shown at numeral 5 is a laser device from which a laser beam is projected. The light spot of the laser beam is reflected by a mirror 6 so as to irradiate the solder portion 4, and the reflected light thereof from the solder portion 4 enters a light receiving unit 7. The laser beam is swept and projected along each solder portion 4 by rotating the mirror 6. The light receiving unit 7 includes a focusing element such as a convex lens 8, and a position sensor such as a PSD (positioning sensitive device) 9.

Each of Figs. 2(a) - 2(c) illustrates part of a method for judging the acceptance or rejection of the external shape of the solder portion 4. In Fig. 2(a), symbol HO denotes the thickness of the lead 3. Regarding an electronic component, such as an ordinary chip capacitor or chip resistor, in which the solder portion 4 is formed on the side wall of the chip, the symbol H0 shall denote the thickness of the chip. The lead thickness or chip thickness H0 differs depending upon the kind of chip. It is accordingly, reasonable to stipulate an allowable upper-limit height of the solder portion 4 as a function αH0 of the thickness H0 (where α is a parameter). The maximum height H1 of the solder portion 4 as measured is compared with the upper-limit height αH0 serving as a criterion for judging whether the solder shape is accepted or rejected. That is, when H1 > αH0 holds, the solder shape is judged N.G. or defective. The parameter α is set in accordance with the kind of chip and is 1.3 by way of example.

Referring to Fig. 2(b), for the same reason as in the above, it is reasonable to set a lower-limit height βH0 (β being a parameter) of the solder portion 4 in accordance with the kind of chip as a second criterion for the acceptance or rejection of the solder shape. The maximum height H2 of the solder portion 4 as measured is compared with the lower-limit height βH0 to judge whether the solder shape is accepted or rejected. That is, when H2 < βH0 holds, the solder shape is judged N.G. or defective. The parameter β is, for example, 0.6.

Referring to Fig. 2(c), it is reasonable to set a lower-limit wetting angle or inclination angle Θ0 of a solder fillet being the solder portion 4, as a third criterion for the acceptance or rejection of the solder shape. Thus, when the wetting angle Θf of the solder fillet 4 as measured is less than the preset lower-limit wetting angle ϑ0, the solder shape is judged N.G.

As described above, when the criteria values αH0, BH0 or Θ0 concerning the acceptance or rejection of the solder shape are set beforehand, acceptance or rejection of the solder shape can be judged objectively and appropriately by comparing the measured results with the criteria values αH0, βH0 or Θ0. Incidentally, the parameters α or β or the lower-limit wetting angle Θ0 vary depending upon the accuracy of the shape required.

Meanwhile, in some chips, for example, a minitransistor as depicted in Fig. 6, the lead 3 is bent to have an abrupt slope along the side wall of the mould member 2a of the chip 2. Regarding such a chip 2, consider a case where the external shape of the solder portion 4 is measured by sweeping and projecting the laser beam along a predetermined measurement area a. In this case, when the chip 2 involves a positional deviation of length ℓ in the direction of the sweeping projection, the laser beam is rejected by the shoulder 3a of the lead 3, and the height of the shoulder 3a is mistakenly recognised as the maximum height H1 of the solder portion 4 as explained before. Accordingly, H1 > αH0 holds to judge the solder shape as being N.G. in spite of being acceptable or non-defective. In the figure, dot-and-dash lines indicate the position of chip 2 without the positional deviation. Such misjudgements are bound to arise, not only in the minitransistor, but also in a chip having leads of abrupt slope, such as a tantalum capacitor or coil, and a chip having long leads extending out sidewardly, such as a QFP (quad flat package) or a SOP (small out-line package). Therefore, a method of measuring the solder portion in such cases will now be described.

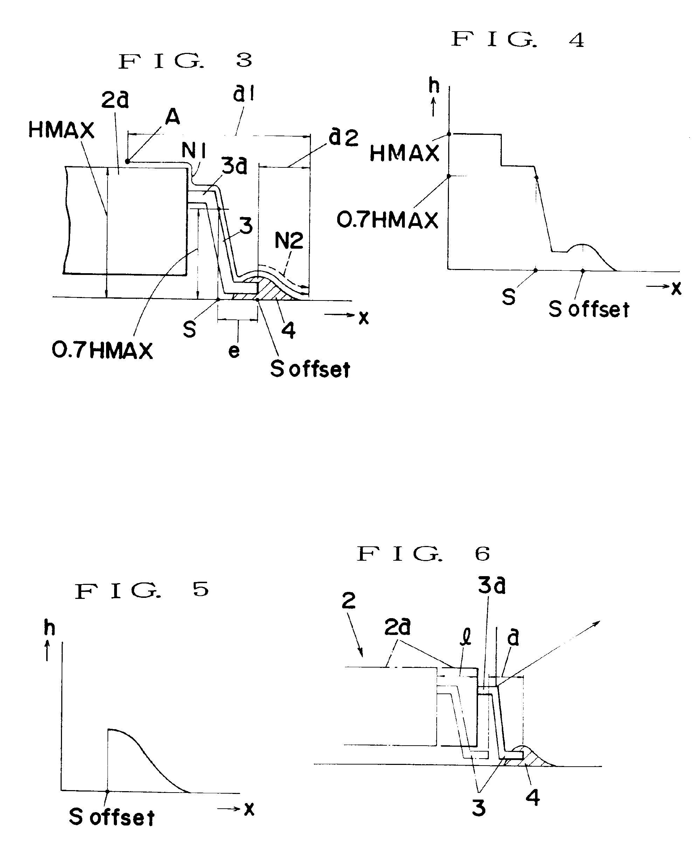

In Fig. 3, it is assumed that the chip 2 involves a considerable positional deviation. Here, a measurement area al is set which is large enough to cover an area extending from the mould member 2a to the outer end of the solder portion 4. The first sweeping projection of the laser beam is carried out from a start point A on the mould member 2a toward the solder portion 4, to thereby measure the external appearance of the chip 2 in the area a1. Symbol N1 denotes a sweep line on this occasion.

Fig. 4 shows the result of the first measurement. In the figure, symbol HMAX denotes the height of the upper surface of the measured mould member 2a. A spot S whose height (for example, 0.7 HMAX) is at a predetermined ration (0.7) to the obtained height HMAX, is located. Subsequently, an offset spot S_{offset} is set at a position which is a predetermined offset distance e away from the spot S toward the outer end of the solder portion 4. Next, a measurement area a2 for the second measurement is set so as to extend from the offset spot S_{offset} to a side at the outer end of the solder portion 4. In the second measurement, the laser beam is swept and projected from a start point corresponding to the offset spot S_{offset}, as indicated by an arrow of broken line N2 in Fig. 3, to thereby measure the external shape of part of the solder portion 4 in detail. Fig. 5 shows the result of the second measurement.

Thus, according to this method, the solder fillet (the part extended at a downward slope from the distal end of the lead) which is very important for judging the acceptance or rejection of the solder shape can be reliably measured. The aforementioned numerical values of 0.7, e, etc. are set beforehand in accordance with the kind of chip and the required accuracy of the solder shape.

Checking of the external shape of the solder portion should desirably be performed at high speed over the largest possible area. In this regard, the method illustrated in Figs. 3 through to 5 has the disadvantage of expending a long time because the operation of sweepingly projecting the laser beam must be carried out twice. Therefore, the first sweeping projection which is done over the larger area in order to determine the start point of the measurement area a2 for the second measurement is executed coarsely (at, for example, 2 mm/100 points), and the second sweeping projection which is done in order to measure the shape of the solder fillet in detail is executed finely (at, for example, 0.5 mm/100 points), whereby the speed of checking can be raised.

As described above, according to the present invention, reasonable criteria for the acceptance or rejection of a solder shape are stipulated, and whether the solder shape is accepted or rejected is judged by comparing measured results with the criteria, so that an appropriate and objective judgement on the acceptance or rejection can be made.

## Claims

1. A method of checking an external shape of a solder portion (4) wherein a laser beam is sweepingly projected along the solder portion (4) and light reflected from the solder portion is detected by a position sensor (7), characterised in that it comprises the steps of:- setting an upper-limit height (αHo) and a lower-limit height (βHo) for the solder portion based on a thickness of either an electronic component (2) or a lead (3) of such component (2), and comparing a maximum height (H₁, H₂) of the measured soldered portion with the set upper-limit height (αHo) and the lower-limit height (βHo) respectively; and setting a lower-limit inclination angle (ΘO) of a solder fillet which forms at least part of the solder portion (4), and comparing an inclination angle (Θf) of the measured solder fillet with the set lower-limit inclination angle (ΘO), whereby the acceptance or rejection of the solder portion shape is judged from the aforesaid comparisons.

2. A method according to claim 1, characterised in that when the solder portion (4) is deposited on a lead (3) extending out from a mould member (2a) of the electronic component (2), it includes the steps of setting a start point (A) on an upper surface of the mould member (2a), and sweepingly projecting the laser beam from the start point (A) toward the solder portion (4) to measure the external shape of the component (2), and subsequently locating a spot (S) which has a height at a predetermined ratio to a height (HMAX) of the upper surface of the mould member, setting an offset spot (S_{OFFSET}) which lies on a side of the solder portion with respect to the located spot (S), and sweepingly projecting the laser beam from the offset spot (S_{OFFSET}) toward the solder portion (4) to measure the external shape of, at least, a part of the solder portion (4).

## Patentansprüche

1. Verfahren zum Prüfen einer äußeren Form eines Lotbereichs (4) bei dem ein Laserstrahl schweifend den Lotbereich (4) entlang projiziert wird und von dem Lotbereich reflektiertes Licht mit Hilfe eines Positions-Meßwertgebers (7) nachgewiesen wird, dadurch gekennzeichnet, daß es umfaßt die Schritte: Einstellen einer oberen Begrenzung der Höhe (αH₀) und einer unteren Begrenzung der Höhe (βH₀) für den Lotbereich auf der Grundlage einer Dicke von entweder einem elektronischen Bestandteil (2) oder einer Leitung (3) eines derartigen Bestandteils (2) und Vergleichen einer maximalen Höhe (H₁, H₂) des vermessenen Lotbereichs mit der eingestellten oberen Begrenzung der Höhe (αH₀) beziehungsweise der unteren Begrenzung der Höhe (βH₀); und Einstellen einer unteren Begrenzung des Neigungswinkels (Θ0) einer zumindest einen Teil des Lotbereichs (4) bildenden Lotrundung, und Vergleichen eines Neigungswinkels (Θf) der vermessenen Lotrundung mit der eingestellten unteren Begrenzung des Neigungswinkels (Θ0), wodurch die Annahme oder Zurückweisung der Lotbereichsform auf der Grundlage der vorgenannten Vergleiche beurteilt wird.

2. Verfahren nach Anspruch 1, dadurch gekennzeichnet, daß es wenn der Lotbereich (4) auf einer sich aus einem Formteil (2a) des elektronischen Bestandteils (2) heraus erstreckenden Leitung (3) abgeschieden ist umfaßt die Schritte des Einstellens eines Startpunktes (A) auf einer oberen Oberfläche des Formteils (2a) und des schweifenden Projizierens des Laserstrahles von dem Startpunkt (A) in Richtung auf den Lotbereich (4) zum Messen der äußeren Form des Bestandteils (2) und des nachfolgenden örtlichen Festlegens eines Flecks (S), der eine Höhe in einem festgelegten Verhältnis zu einer Höhe (HMAX) der oberen Oberfläche des Formteils aufweist, Einstellen eines bezüglich des örtlich festgelegten Flecks (S) auf einer Seite des Lotbereichs liegenden Versatzflecks (S_{OFFSET}) und schweifendes Projizieren des Laserstrahles von dem Versatzfleck (S_{OFFSET}) in Richtung auf den Lotbereichs (4) zum Messen der äußeren Form von zumindest einem Teil des Lotbereichs (4).

## Revendications

1. Procédé de vérification de la forme extérieure d'un point de brasure (4), dans lequel un rayon laser est projeté avec balayage le long du point de brasure (4) et la lumière réfléchie par le point de brasure est détectée par un capteur de position (7), caractérisé en ce qu'il comprend les étapes consistant: à fixer une hauteur limite supérieure (αHo) et une hauteur limite inférieure (βHo) pour le point de brasure sur la base de l'épaisseur d'un composant électronique (2) ou d'une patte de connexion (3) d'un tel composant (2), et à comparer une hauteur maximale (H₁, H₂) du point de brasure mesuré, respectivement à la hauteur limite supérieure (αHo) et à la hauteur limite inférieure (βHo) fixées; et à fixer un angle d'inclinaison limite inférieur (ϑO) d'un flanc de la brasure qui forme au moins une partie du point de brasure (4), et à comparer un angle d'inclinaison (ϑf) du flanc de la brasure mesuré à l'angle d'inclinaison limite inférieur fixé (ϑO), l'acceptation ou le rejet de la forme du point de brasure étant jugé d'après lesdites comparaisons.

2. Procédé selon la revendication 1, caractérisé en ce que le point de brasure (4) est déposé sur une patte de connexion (3) qui sort d'un élément moulé (2a) du composant électronique (2), et en ce qu'il comprend les étapes consistant à fixer un point de départ (A) sur la surface supérieure de l'élément moulé (2a) et à projeter le rayon laser avec balayage depuis le point de départ (A) vers le point de brasure (4) pour mesurer la forme extérieure du composant (2), puis à localiser un endroit (S) dont la hauteur est dans un rapport prédéterminé avec la hauteur (HMAX) de la surface supérieure de l'élément moulé, à fixer un endroit décalé (S_{OFFSET}) qui est situé sur un côté du point de brasure par rapport à l'endroit localisé (S), et à projeter le rayon laser avec balayage depuis l'endroit décalé (S_{OFFSET}) vers le point de brasure (4) pour mesurer la forme d'une partie au moins du point de brasure (4).
